(19) Europäisches Patentamt
European Patent Office
Office européen des brevets

(11) **EP 2 297 798 B1**

(12) **EUROPÄISCHE PATENTSCHRIFT**

(45) Veröffentlichungstag und Bekanntmachung des Hinweises auf die Patenterteilung:
**03.08.2016   Patentblatt 2016/31**

(21) Anmeldenummer: **09765822.3**

(22) Anmeldetag: **15.06.2009**

(51) Int Cl.:
**H01L 41/083** (2006.01)    **H01L 41/04** (2006.01)

(86) Internationale Anmeldenummer:
**PCT/EP2009/057377**

(87) Internationale Veröffentlichungsnummer:
**WO 2009/153242 (23.12.2009 Gazette 2009/52)**

(54) **VERFAHREN ZUR ABSTIMMUNG EINER RESONANZFREQUENZ EINES PIEZOELEKTRISCHEN BAUELEMENTES**

METHOD FOR TUNING A RESONANT FREQUENCY OF A PIEZOELECTRIC COMPONENT

PROCÉDÉ D'ACCORD D'UNE FRÉQUENCE DE RÉSONANCE D'UN COMPOSANT PIÉZOÉLECTRIQUE

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(30) Priorität: **18.06.2008   DE 102008028885**

(43) Veröffentlichungstag der Anmeldung:
**23.03.2011   Patentblatt 2011/12**

(73) Patentinhaber: **Epcos AG**
**81669 München (DE)**

(72) Erfinder:
• ENGEL, Günter
  **A-8430 Leibnitz (AT)**
• **HUAINIG, Michael**
  **A-9020 Klagenfurt am Wörthersee (AT)**
• **PUFF, Markus**
  **A-8010 Graz (AT)**
• **WIPPEL, Thomas**
  **A-8510 Stainz (AT)**

(74) Vertreter: **Epping - Hermann - Fischer Patentanwaltsgesellschaft mbH Schloßschmidstraße 5 80639 München (DE)**

(56) Entgegenhaltungen:
EP-A- 1 126 602    WO-A-2008/090095
US-A- 5 446 306

**Beschreibung**

Die Erfindung betrifft ein Verfahren zur Abstimmung einer Resonanzfrequenz eines piezoelektrischen Bauelementes. Ein piezoelektrisches Bauelement ist beispielsweise aus der Druckschrift US 6,346,764 B1 bekannt.

Derartige piezoelektrische Bauelemente kommen in einer Vielzahl von Anwendungen zum Einsatz. Eine typische Anwendung sind Aktuatoren, bei denen ein piezoelektrisches Bauelement durch eine Steuerspannung zu Schwingungen, beispielsweise zu Biegeschwingungen oder Streckschwingungen angeregt wird. Eine natürliche Resonanzfrequenz des piezoelektrischen Bauelementes ergibt sich dabei aus den geometrischen Abmessungen des Bauelementes in Verbindung mit elastischen Eigenschaften, welche die Antwort auf die zugeführte Anregung charakterisieren. Um die Dämpfung bei einer Anregung möglichst gering zu halten, ist es zweckmäßig, das piezoelektrische Bauelement so auszugestalten, dass dessen natürliche Resonanzfrequenz der gewünschten Anregungsfrequenz entspricht.

Die Druckschrift EP 1 126 602 zeigt einen Piezoresonator mit übereinander angeordneten Elektroden. Zur Einstellung und Abstimmung der Resonanzfrequenz ist eine Gleichspannungsquelle vorgesehen, die mit zwei benachbarten Elektrodenschichten gekoppelt ist. Eine Wechselspannungsquelle steuert eine der Elektrodenschichten und eine weitere Elektrodenschicht an.

In der Druckschrift US 5,446,306 ist ein SBAR-Bauelement in Dünnfilmtechnologie gezeigt, bei dem eine piezoelektrische

Schicht zwischen Elektroden angeordnet ist. Mittels einer variablen Gleichspannung, die zwischen den Elektroden angelegt wird, lässt sich die Resonanzfrequenz des SBAR-Bauelements verändern.

Es besteht das Bedürfnis, piezoelektrische Bauelemente sowie schwingfähige Bauelementeanordnung mit einem piezoelektrischen Bauelement hinsichtlich ihrer Resonanzfrequenz abzustimmen.

Diesem Bedürfnis wird durch die Gegenstände des Patentanspruchs 1 Rechnung getragen. Gemäß einer Ausführungsform wird ein Verfahren zur Abstimmung einer Resonanzfrequenz eines piezoelektrischen Bauelementes vorgeschlagen.

Hierbei umfasst das piezoelektrische Bauelement wenigstens einen in drei Raumrichtungen ausgedehnten Wandler, wobei die Resonanzfrequenz des Wandlers und damit auch des Bauelements abhängig von einer Ausdehnung in mindestens eine der Raumrichtungen und/oder einer materialabhängigen elastischen Eigenschaft ist. Der Wandler umfasst eine Schichtstruktur mit wenigstens vier alternierend übereinander angeordneten Elektroden, wobei erste Elektroden und zweite Elektroden mit den an beiden Enden angebrachte Flächen des Bauelementes verbunden sind, dritte Elektroden an eine dritte Fläche und vierte Elektroden an eine vierte Fläche angeschlossen sind, wobei dritte und vierte Flächen entlang der Längsrichtung des Bauelementes angeordnet sind. Letztere ist zwischen den wenigstens zwei ersten Elektroden angeordnet. In einer Ausführungsform umfasst der Wandler somit mehrere Elektroden, die alternierend übereinander gestapelt sind.

Nach dem vorgeschlagenen Prinzip wird nun eine Gleichspannung an zwei der vier Flächen angelegt. Dadurch wird eine Änderung in der Resonanzfrequenz hervorgerufen, da die angelegte Gleichspannung eine Änderung der Ausdehnung des Wandlers in wenigstens eine der drei Raumrichtungen und/oder eine Änderung der elastischen Eigenschaft hervorruft. Ebenso wird eine Steuerspannung zur Erzeugung einer Schwingung an die anderen zwei der vier Flächen mit einer Anregungsfrequenz angelegt, die im Wesentlichen der geänderten Resonanzfrequenz entspricht.

Eine Anpassung bzw. Abstimmung der Resonanzfrequenz des piezoelektrischen Bauelementes erfolgt somit durch eine Änderung der geometrischen Abmessungen des Bauelementes bzw. wenigstens einer Komponente der elastischen Eigenschaft durch das Anlegen einer Gleichspannung.

Auf diese Weise können verschiedene piezoelektrische Bauelemente mit Wandlern leicht unterschiedlich geometrischer Abmessungen hinsichtlich ihrer natürlichen Resonanzfrequenz aneinander angepasst werden. Dies erfolgt, indem unterschiedliche Gleichspannungen an die zwei der vier Flächen angelegt werden. Die angelegte Gleichspannung führt zu einer Änderung der geometrischen Abmessungen des Wandlers bzw. einer oder mehrerer Komponenten der elastischen Eigenschaft. Dadurch ändert sich die Resonanzfrequenz, welche einerseits von der elastischen Eigenschaft und andererseits der wenigstens einen Raumrichtung abhängig ist. Durch eine geeignet angelegte Gleichspannung können so die Resonanzfrequenzen unterschiedlicher piezoelektrischer Bauelemente aneinander angepasst werden.

Die elastische Eigenschaft kann aus einem Elastizitätsmodul abgeleitet sein und/oder eine oder mehrere Komponenten hiervon darstellen.

In einem zweiten Schritt wird nun eine Steuerspannung mit einer Anregungsfrequenz an die anderen zwei der vier Flächen angelegt, wobei die Anregungsfrequenz der Steuerspannung im Wesentlichen der geänderten Resonanzfrequenz entspricht. Die Steuerspannung ist im Wesentlichen eine Wechselspannung.

Im Ergebnis wird so eine Anpassung der Resonanzfrequenz unterschiedlicher piezoelektrischer Bauelemente aneinander erreicht, ohne die Geometrie des Bauelementes, beispielsweise deren Außenabmessungen, mechanisch ändern zu müssen. Insbesondere lassen sich so Resonanzfrequenzen von piezoelektrischen Bauteilen, welche fertigungsbedingte Streuungen der geometrischen Abmessungen zueinander aufweisen, ohne eine mechanische Bearbeitung aufeinander abstimmen bzw. reversibel auf einen vordefinierten Wert einstellen. Die Fertigungskosten, insbesondere zur genauen Frequenzeinstellung der Resonanzfrequenzen durch eine entsprechend mechanische Bearbeitung können somit entfallen. Darüber hinaus ist es möglich, Änderungen in der Resonanzfrequenz der Bauelemente, hervorgerufen durch externe nicht beeinflussbare Parameter, kompensieren zu können. Beispielsweise kann mit dem vorgeschlagenen Verfahren eine Temperaturkompensation der Resonanzfrequenz piezoelektrischer Bauelemente vorgenommen werden.

Eine Abstimmung mit einer Gleichspannung ist auch möglich, weil das so genannte mechanische Kapazitätsäquivalent die Resonanzfrequenz des Bauelements mit bestimmt und gleichzeitig spannungsabhängig ist. Aus energetischer Sicht betrachtet versucht das Bauelement bei Anlegen eines elektrischen Feldes zu einem möglichst günstigen d.h. niedrigen Energiezustand zu gelangen. Entsprechend erzeugt die angelegte Gleichspannung ein elektrisches Vektorfeld, welches auf das Bauelement und die piezoelektrisches Material wirkt. In Antwort auf das Feld ändert das Bauelement seine geometrischen Abmessungen in eine oder mehrere Raumrichtungen und/oder eine oder mehrere Komponenten des Elastizitätsmoduls. Natürlich ist die Änderung von der Richtung des Feldes abhängig.

In einer vorteilhaften Ausgestaltung besitzt der ausgedehnte Wandler eine Mehrschichtstruktur, bei der eine Vielzahl Elektroden übereinander angeordnet sind. Dies erlaubt geringere Spannungen, um die gleichen Feldstärken in den piezoelektrischen Schichten zu erreichen.

Durch eine entsprechende Ausgestaltung des Wandlers, darunter auch durch eine geeignete Wahl des Materials, der Anzahl und der Schichtstärke einzelner piezoelektrischer Schichten sowie der lateralen Dimension des Wandlers kann eine Umsetzung elektrischer Energie bevorzugt dort durchgeführt werden, wo die Anregung mechanischer Schwingungen erwünscht ist.

Für piezoelektrische Schichten kommen PZT-Keramiken mit beliebiger Rezeptur, aber auch andere geeignete piezoelektrische Keramiken mit geringem Verlustwinkel in Betracht. Die einzelnen keramischen Schichten zwischen den Elektroden können gleiche Schichtdicke sowie gleichen Abstand voneinander aufweisen. Es ist jedoch auch möglich, hier unterschiedliche Schichtdickenabstände oder auch Materialien zu verwenden, um so die gewünschte Anregung und mechanische Schwingung zu erreichen.

In einer weiteren Ausgestaltung umfasst die Schichtstruktur des Wandlers eine erste Teilschichtstruktur oder eine hiervon durch einen im Wesentlichen feldfreien Raum beabstandete zweite Teilschichtstruktur. Jede der beiden Teilschichtstrukturen enthält wiederum eine Mehrzahl übereinander angeordneter Elektroden. Die beiden Teilschichtstrukturen sind nebeneinander, aber in einem Abstand voneinander angeordnet. Durch die Einführung des spannungs- und deformationsfreien neutralen Bereichs zwischen den beiden Teilschichtstrukturen sind sie mechanisch voneinander entkoppelt. Dadurch können die beiden Teilschichtstrukturen bzw. deren Elektroden mit unterschiedlichen Steuerspannung beaufschlagt werden. Vorzugsweise weisen die beiden benachbarten Teilschichtstrukturen im Wesentlichen den gleichen oder zueinander symmetrischen Aufbau und insbesondere im Wesentlichen das gleiche mechanische Kapazitätsäquivalenz auf.

Das piezoelektrische Bauelement zeichnet sich durch eine hohe Energiedichte aus, die auf einen vergleichsweise kleinen Raum konzentriert ist. Die Kapazitätsverteilung im piezoelektrischen Bauelement ist für den aufgenommenen Strom und die Verluste maßgeblich. Somit lässt sich mittels Erfassen der Verlustleistung einer zugeführten Steuerspannung eine Aussage über die Dämpfung und damit die Abweichung der Anregungsfrequenz zur natürlichen Resonanzfrequenz bei einer Schwingung des piezoelektrischen Bauelementes treffen.

Zu diesem Zweck wird in einer Ausführungsform des Verfahrens eine Steuerspannung mit einer Anregungsfrequenz zur Erzeugung einer Schwingung, bevorzugt einer Biegeschwingung angelegt. Anschließend wird ein von der erzeugten Schwingung abhängiger Parameter erfasst. Eine Gleichspannung führt zu Änderungen der Resonanzfrequenz des Bauelementes, wodurch sich bei einem weiteren gleichzeitigen Anlegen der Steuerspannung mit der Anregungsfrequenz auch der von der Schwingung abhängige Parameter ändert. Dieser wird erneut erfasst und mit dem bereits vorher erfassten Parameter verglichen. In Antwort auf diesen Vergleich wird die angelegte Gleichspannung geändert.

Auf diese Weise kann die natürliche Resonanzfrequenz des Bauelementes durch geeignetes Anlegen einer Gleichspannung auf die Anregungsfrequenz abgestimmt werden. Dies erfolgt in mehreren Schritten, wobei der erfasste Parameter eine Aussage darüber erlaubt, ob die angelegte Gleichspannung zur Änderung der Resonanzfrequenz eine Verringerung der Dämpfung und damit eine Änderung der Resonanzfrequenz in Richtung auf die Sollresonanzfrequenz hin erfolgt. Stimmen Anregungsfrequenz und abgestimmte Resonanzfrequenz überein, so hat die Dämpfung ein globales Minimum erreicht.

In einer Ausgestaltung wird die Amplitude der erzeugten Schwingung bzw. die Auslenkung des Wandlers ausgewertet. Diese ist umso höher, je kleiner die Abweichung zwischen der durch die Gleichspannung abgestimmten Resonanzfrequenz und die Anregungsfrequenz der Steuerspannung ist. Alternativ kann auch die Dämpfung der erzeugten Schwingung bzw. der zeitliche Verlauf der erzeugten Schwingung ausgewertet werden. Bei einer geringeren Dämpfung ist der zeitliche Abfall der Amplitude der erzeugten Schwingung entsprechend geringer. Entsprechend kann die zeitliche Amplitudenänderung in einer weiteren Ausgestaltungsform erfasst und ausgewertet werden.

Alternativ ist es auch möglich, die Verlustleistung abgeleitet aus der zugeführten Steuerspannung auszuwerten. Diese erreicht ein Minimum, sofern die natürlich Resonanzfrequenz des Bauelementes der Anregungsfrequenz der Steuerspannung und damit der Sollresonanzfrequenz entspricht.

Es kann zweckmäßig sein, den Abstand zwischen den Elektrodenebenen des Wandlers, das heißt die Dicke der jeweiligen piezoelektrischen Schicht, in unterschiedlichen lateralen Bereichen des Körpers unterschiedlich zu wählen. Dadurch können möglichst große Biegespannungen erzielt werden. Durch den kleinen Elektrodenabstand erhöht sich bei gleich bleibender elektrischer Spannung die Feldstärke in der jeweiligen piezoelektrischen Schicht. Die Dicke der piezoelektrischen Schichten kann daher in solchen Bereichen des piezoelektrischen Bauelementes beziehungsweise des Wandlers verringert werden, in denen die größte Auslenkung des Körpers zur Erzielung einer großen Biegespannung angestrebt wird.

Die jeweilige piezoelektrische Schicht ist durch eine polare Achse gekennzeichnet. Vorzugsweise sind piezoelektrische Schichten mit positiver und negativer Polungsrichtung alternierend übereinander angeordnet. Zur Einstellung einer Vorzugsrichtung von Domänen können die piezoelektrischen Schichten des Körpers vorpolarisiert werden. Das Polarisationsfeld kann zum Beispiel 1 kV/mm bis 3 kV/mm betragen. Im Betrieb kann dann pro Schicht ein elektrisches Feld bis zu 200 V/mm erreicht werden.

Im Folgenden wird die Erfindung anhand verschiedener Ausführungsformen unter Bezugnahme auf die Zeichnungen im Detail erläutert. Es zeigen:

Figur 1      eine nicht erfindungsgemäße Ausführungsform eines piezoelektrischen Bauelementes,

Figur 2A      eine weitere nicht erfindungsgemäße Ausführungsform eines elektrischen Bauelementes,

Figur 2B      eine Draufsicht auf das piezoelektrische Bauelement gemäß Figur 2A,

Figur 2C      eine weitere Draufsicht auf das piezoelektrische Bauelement gemäß Figur 2A,

Figur 3A      eine Querschnittsansicht eines piezoelektrischen Bauelementes nach einer weiteren nicht erfindungsgemäßen Ausführungsform,

Figur 3B      eine Draufsicht auf das piezoelektrische Bauelement gemäß Figur 3A,

Figur 4A      eine Querschnittsdarstellung einer erfindungsgemäßen Ausführung eines piezoelektrischen Bauelementes,

Figur 4B      eine Draufsicht auf das piezoelektrische Bauelement nach Figur 4A,

Figur 5      eine schematische Darstellung eines Aktuators mit zwei senkrecht zueinander angeordneten, nicht erfindungsgemäßen piezoelektrischen Bauelementen,

Figur 6      eine Querschnittsansicht einer weiteren Anordnung eines Aktuators mit zwei nicht erfindungsgemäßen piezoelektrischen Bauelementen,

Figur 7      eine Ausführung des Verfahrens zur Abstimmung einer Resonanzfrequenz,

Figur 8      ein Diagramm zur Darstellung der Abhängigkeit der Resonanzfrequenz von einer angelegten Steuerspannung.

Die in den folgenden Figuren dargestellten und erläuterten Ausführungsformen sind in ihren einzelnen Elementen nicht maßstabsgerecht gezeichnet. Insbesondere können einzelne Elemente zur näheren Verdeutlichung übertrieben groß beziehungsweise klein dargestellt werden. Einzelne nur in bestimmten Ausführungen angesprochene Aspekte, beispielsweise Schichtdicken, Abstände oder Materialien lassen sich ohne weiteres auch auf die anderen Ausführungen übertragen. Unter dem Begriff "elastische Eigenschaft" wird im Folgenden ein materialabhängiger elastischer Parameter verstanden. Dieser kann eine oder mehrere Komponenten eines Elastizitätsmoduls oder eines Kompressionsmoduls sein und beschreibt die Antwort des piezoelektrischen Materials auf ein äußeres angelegtes Feld. Umgekehrt soll von dem Begriff Elastizitätsmodul eine elastische Eigenschaft verstanden werden, welche eine mechanische Antwort auf ein äußeres angelegtes Feld beschreibt. Die elastische Eigenschaft kann durch einen Tensor, einen Vektor oder ein Skalar dargestellt werden. Wirkungs- und funktionsgleiche Bauelemente tragen die gleichen Bezugszeichen.

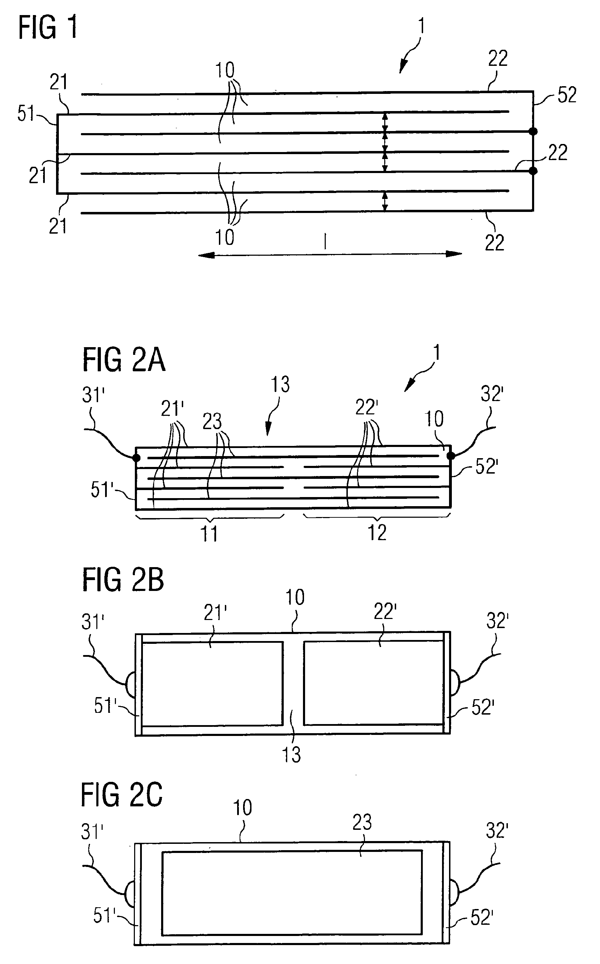

Das nicht erfindungsgemäße piezoelektrische Bauelement 1 gemäß Figur 1 umfasst einen Wandler, der eine Vielzahl piezoelektrischer Schichten 10 und Elektronenebenen aufweist. Diese sind in abwechselnder Reihenfolge übereinander gestapelt angeordnet. Die piezoelektrischen Schichten 10 umfassen in dieser Ausgestaltung ein vorpolarisiertes Keramikmaterial. Das piezoelektrische Bauelement 1 besitzt eine Vielzahl erster Elektroden 22 sowie zweite Elektroden 21. Diese sind jeweils von einer piezoelektrischen Schicht 10 beabstandet alternierend übereinander angeordnet. Die ersten Elektroden 22 sind über eine leitende Fläche 52 miteinander verbunden. Entsprechend verbindet eine leitende Fläche 51 die Elektroden 21 des Wandlers.

Die natürliche Resonanzfrequenz $f_{res}$ des piezoelektrischen Bauelementes ist unter anderem abhängig von der effektiven Masse $m_{eff}$ des Bauelementes, welche sich aus den geometrischen Abmessungen, der Dichte $\rho$ des Bauelementes und dem materialabhängigen Elastizitätsmodul S ergibt. Letzteres ist ein Tensor und charakterisiert die Antwort des piezoelektrischen Materials auf eine konstante elektrische Feldstärke E. Im Allgemeinen gilt somit, dass die Resonanzfrequenz im Fall eines piezoelektrischen Quer- beziehungsweise Transversaleffektes, dem so genannten d31-Effekt, in erster Näherung indirekt proportional zur Länge ist. Für das in Figur 1 dargestellte Bauelement mit der Vielschichtstruktur und einer lateralen Ausdehnung in Richtung l gilt:

$$f_{res} \propto \frac{1}{2\pi} \cdot \sqrt{\frac{1}{L_m \cdot C_m}} \quad (1),$$

wobei Lm das mechanische Induktivitätsäquivalent und Cm das mechanische Kapazitätsäquivalent darstellt. Da die Äquivalente abhängig von den Dimensionen und dem Material des Bauelementes sind gilt weiterhin in erster Näherung

$$f_{res} \propto \frac{1}{l_a} \cdot \sqrt{\frac{1}{\rho \cdot s_{11}} \cdot \frac{V_a}{d \cdot l_a^2 \cdot \left(4 \cdot l_a \cdot b_{iso} + l_a \cdot b_a\right)}} \quad (2),$$

wobei $l_a$ die aktive Länge des piezoelektrischen Bauelementes, $\rho$ die Dichte des Bauelementes und $S_{11}$ die entsprechende Komponente des Elastizitätsmoduls S ist. Die Variable d gibt die Dicke des Bauelementes an und $b_a$ bzw. $b_{iso}$ die aktive Breite bzw. die Breite der Isolationsschicht an.

Wird nun eine Gleichspannung an die Elektroden 22 beziehungsweise 21 angelegt, so bildet sich zwischen ihnen ein elektrisches Feld aus, welches aufgrund des piezoelektrischen Transversaleffektes zu einer Längenänderung des Bauelementes führt. Dies ergibt sich aus der Komponente $s_{11}$, welche ungleich 0 ist. Darüber hinaus kann auch die Komponente $S_{11}$ des Bauelementes in gewissem Ausmaß von der Gleichspannung abhängig sein. Durch das Anlegen der Gleichspannung wird somit die Ausdehnung des piezoelektrischen Bauelementes beziehungsweise des Elastizitätsmoduls verändert. Dadurch ergibt sich ebenfalls eine Verschiebung der natürlichen Resonanzfrequenz $f_{res}$ des piezoelektrischen Bauelementes. Dies ist in der Gleichung (2) in erster Näherung dargelegt, aus der eine proportionale Abhängigkeit der Resonanzfrequenz $f_{res}$ von der Wurzel der angelegten Gleichspannung $V_a$ hervorgeht.

Zur Abstimmung des piezoelektrischen Bauelementes 1 gemäß Figur 1 kann nun eine Gleichspannung im Bereich einiger 10 V, bevorzugt im Bereich von -40 V bis +50 V an die Elektroden 21, 22 angelegt werden. Dies führt zu einer Änderung der aktiven Länge und damit eine Änderung der Resonanzfrequenz des Bauelementes. Durch die geeignete Wahl einer angelegten Gleichspannung kann somit die Resonanzfrequenz in einer gewünschten Weise verändert und auf eine Anregungsfrequenz einer ebenfalls an die Elektroden angelegten Steuerspannung abgestimmt werden.

Figur 2A zeigt eine weitere nicht erfindungsgemäße Ausführungsform eines piezoelektrischen Bauelementes 1 mit einem Wandler, der zwei Teilbereiche 11 beziehungsweise 12 aufweist. Diese sind von einem neutralen Bereich 13 beabstandet, der sich im Querschnitt gemäß Figur 2A in einer Vertikalrichtung senkrecht zu einer Längsachse des Wandlers erstreckt. Der Wandler umfasst in seinem ersten Teilbereich 11 erste Elektroden 21', die mittels einer ersten elektrischen, leitenden Fläche 51' miteinander verbunden sind. In seinem zweiten Teilbereich 12 enthält der Wandler zweite Elektroden 22', die über die Fläche 52' miteinander verbunden sind. An beide Flächen sind jeweils Kontaktelemente 31', 32' zur elektrischen Kontaktierung angeschlossen.

Zwischen den ersten Elektroden 21' im ersten Teilbereich und den zweiten Elektroden 22' im zweiten Teilbereich 12 sind jeweils dritte Elektroden 23 angeordnet. Die ersten Elektroden 21' des ersten Teilbereichs 11, die zweiten Elektroden 22' des zweiten Teilbereichs 12 sind jeweils galvanisch von den dritten Elektroden 23 getrennt. Die dritten Elektroden verlaufen durch den neutralen Bereich 13 und verbinden somit die beiden Teilbereiche 11 und 12 miteinander. In dieser Ausführungsform sind die dritten Elektroden 23 floatend angeordnet und besitzen keine Verbindung zu einer Oberfläche des Bauelementes.

Figur 2B zeigt diesbezüglich eine Draufsicht von oben auf das piezoelektrische Bauelement 1. Zu erkennen sind die beiden Flächen der ersten Elektroden 21' und der zweiten Elektroden 22' in den einzelnen Teilbereichen 11 und 12 des Wandlers. Die ersten Elektroden 21' sind über die gemeinsame Fläche 51' mit einem Kontaktelement 31' verbunden. Entsprechend kontaktiert die Fläche 52' die Elektroden 22' des zweiten Teilbereichs. Zwischen den beiden Elektroden 21', 22' ist im neutralen Bereich 13 die piezoelektrische Schicht 10 zu erkennen. Figur 2C stellt diesbezüglich eine weitere Draufsicht durch das piezoelektrische Bauelement in einer Ebene dar, in der die dritte Elektrode 23 verläuft. Diese floatend ausgebildete Elektrode ist galvanisch von den querseitig an beiden Enden angeordneten Flächen 51' beziehungsweise 52' und damit von den ersten und zweiten Elektroden getrennt.

In einem Betrieb der Anordnung wird das piezoelektrische Bauelement durch eine Steuerspannung mit einer Anregungsfrequenz zu Schwingungen angeregt. Dies können vorliegend Biegeschwingungen sein, die senkrecht zur Längsrichtung des piezoelektrischen Bauelementes verlaufen. Vorzugsweise wird den ersten Elektroden 21' im ersten Teilbereich 11 und den zweiten Elektroden 22' im zweiten Teilbereich 12 die gleiche Steuerspannung, insbesondere mit gleicher Anregungsfrequenz zugeführt. Sofern die Anregungsfrequenz nicht der natürlichen Resonanzfrequenz des piezoelektrischen Bauelementes entspricht, kommt es hierbei zu mehr oder weniger starker Dämpfung. Dadurch steigt die elektrische Verlustleistung an und der Wirkungsgrad des Bauelementes wird reduziert. Zur Abstimmung der natürlichen Resonanzfrequenz auf die gewünschte Anregungsfrequenz wird nun in einer Ausgestaltung zusätzlich eine Gleichspannung an die ersten und zweiten Elektroden der beiden Teilbereiche 11 und 12 angelegt. Dies führt zu einer Änderung der geometrischen Abmessungen, beispielsweise einer Längenänderung des piezoelektrischen Bauelementes, sowie gegebenenfalls zu einer Änderung einzelner Komponenten des Elastizitätsmoduls. Folglich verschiebt sich auch die Resonanzfrequenz.

Durch die geringen Abstände und Dicken der piezoelektrischen Schichten 10 zwischen den einzelnen Elektroden 21 beziehungsweise 22 sind die aus der Gleichspannung resultierenden Feldstärken sehr groß, sodass auch bei geringen Gleichspannungen im Bereich weniger 10 V ausreichend hohe Feldstärken für eine signifikante Änderung der räumlichen Ausdehnung beziehungsweise des Elastizitätsmoduls erreicht werden. Dadurch ist eine Abstimmung auch mit geringen Gleichspannungen möglich.

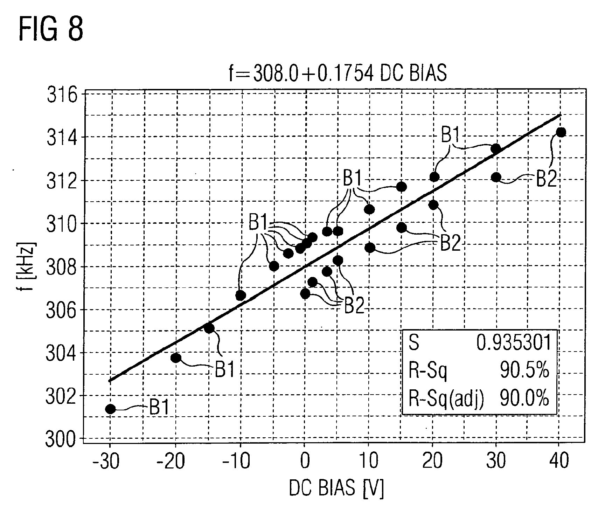

Figur 8 zeigt hierzu ein Diagramm zur Verdeutlichung des Zusammenhangs zwischen zugeführter Gleichspannung und Änderung der Resonanzfrequenz. In dieser Ausgestaltung zeigen die zwei vermessenen piezoelektrischen Bauelemente B1, B2 Resonanzfrequenzen im Bereich von 300 bis 316 kHz. Wie dargestellt, führen geringfügige Variationen in den geometrischen Abmessungen unterschiedlicher piezoelektrischer Bauelemente B1, B2 zu unterschiedlichen natürlichen Resonanzfrequenzen. Beispielsweise schwanken die natürlichen Resonanzfrequenzen bei nicht angelegter Gleichspannung der Bauelemente B1, B2 zwischen 307 kHz und 309 kHz.

Zur Abstimmung beziehungsweise Änderung der natürlichen Resonanzfrequenz wird nun zusätzlich eine Gleichspannung an ein oder beide piezoelektrische Bauelemente angelegt. Dies führt zu einer im Wesentlichen proportionalen Änderung der Resonanzfrequenz, wie es durch den linearen Fit der Figur 8 dargestellt ist. Folglich lässt sich so ein piezoelektrisches Bauelement, welches aufgrund seiner geometrischen Abmessungen eine gegenüber einer gewünschten Anregungsfrequenz leicht unterschiedliche Resonanzfrequenz aufweist, durch das Anlegen einer Gleichspannung auf die gewünschte Anregungsfrequenz abstimmen. Zudem können verschiedene piezoelektrische Bauelemente mit leicht unterschiedlichen Resonanzfrequenzen durch das Anlegen entsprechend geeigneter Gleichspannungen auf eine gemeinsame Resonanzfrequenz abgestimmt werden.

Sollen beispielsweise die Bauelemente B1, B2 beide auf eine Resonanzfrequenz von 308 kHz abgestimmt werden, so wird B1 mit einer Gleichspannung von -5 V und das Bauelement B2 mit einer Gleichspannung von +5 V beaufschlagt.

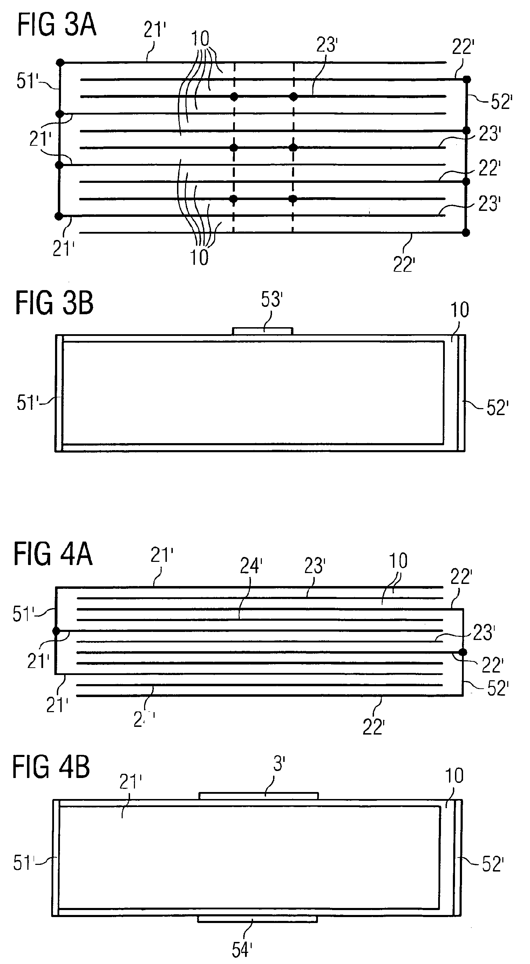

Zur Abstimmung eignen sich neben den bereits dargestellten weitere Vielschichtanordnungen für piezoelektrische Bauelemente. Figuren 3A, 3B sowie 4A und 4B zeigen diesbezüglich mögliche Ausgestaltungen.

Gemäß der in Figur 3A gezeigten nicht erfindungsgemäßen Ausführungsform eines piezoelektrischen Bauelements sind abwechselnd drei unterschiedliche Elektroden übereinander angeordnet und durch piezoelektrische Schichten 10 im Bereich weniger $\mu$m Dicke voneinander beabstandet. Die ersten Elektroden 21' sind über eine gemeinsame Fläche 51' elektrisch miteinander verbunden und galvanisch von den dazwischen liegenden Elektroden 22' und 23' getrennt. Zweite Elektroden 22' sind über eine zweite elektrisch leitende Fläche 52' miteinander verbunden. Die dritten Elektroden 23' sind, wie in der Draufsicht auf Figur 3B dargestellt, an eine gemeinsame Fläche 53' angeschlossen, die entlang der Längsseite auf dem piezoelektrischen Bauelement angeordnet ist. Auf diese Weise können entsprechende Gleich- beziehungsweise Steuerspannungen an die verschiedenen Elektroden gelegt werden, um einerseits die gewünschte Biegeschwingung und andererseits eine entsprechende Abstimmung des piezoelektrischen Bauelementes zu erreichen. Beispielsweise kann ein Gleichspannungspotential oder eine Gleichspannung an die Fläche 51' und ein Wechselspannungspotential oder eine Wechselspannung an die Fläche 52' angelegt werden. Die Elektroden 23' werden über die Anschlussfläche 53' mit einem Massepotential beaufschlagt und auf Masse gelegt. Natürlich lässt sich auch dieses Bauelement in einzelne Teilbereiche unterteilen, die separat angesteuert werden.

Figur 4A zeigt eine erfindungsgemäße Ausgestaltungsform eines piezoelektrischen Bauelements, die sich vor allem durch eine symmetrische Anordnung einzelner Elektroden auszeichnet. In diesem Ausführungsbeispiel sind vier unterschiedliche Elektroden 21' bis 24' alternierend übereinander angeordnet. Erste Elektroden 21' und zweite Elektroden 22' sind jeweils mit den an beiden Enden angebrachten Flächen 51' bzw., 52' des Bauelementes verbunden. Dritte Elektroden 23' sind an die Fläche 53' und vierte Elektroden 24' an die Fläche 54' angeschlossen. Die beiden zusätzlichen Flächen 53' und 54' sind, wie in Figur 4B gezeigt, entlang der Längsrichtung des Bauelementes angeordnet. Über die entsprechenden Flächen 51' bis 54' lassen sich Wechsel- beziehungsweise Gleichspannungen an die verschiedenen Elektroden legen. Beispielsweise kann eine Steuerspannung mit einer Anregungsfrequenz an die Flächen 51' beziehungsweise 52' angelegt werden, während gleichzeitig eine Gleichspannung über die Flächen 53' und 54' dem Bauelement zugeführt wird. Damit ist eine Entkopplung von Wechsel- und Gleichspannung möglich.

Darüber hinaus können die Dicken der verschiedenen piezoelektrischen Schichten 10 zwischen den einzelnen Elektroden 21' bis 24' unterschiedlich gewählt werden. Dies erlaubt einen möglichst großen Abstimmungsbereich mit nur geringen angelegten Gleichspannungen bei gleichzeitig hoher Auslenkung in einer Biegeschwingung bei angelegter Steuerspannung zu realisieren.

Piezoelektrische Bauelemente nach dem vorgeschlagenen Prinzip werden in einer Vielzahl von Anwendungen, beispielsweise als Aktuatoren, eingesetzt. Durch das Anlegen einer Steuerspannung mit einer Anregungsfrequenz führen die piezoelektrischen Bauelemente Schwingungen aus, die durch eine geeignete mechanische Kopplung übertragen werden können. Auf diese Weise lassen sich piezoelektrische Motoren, Pumpen, Trafos oder Membrane realisieren.

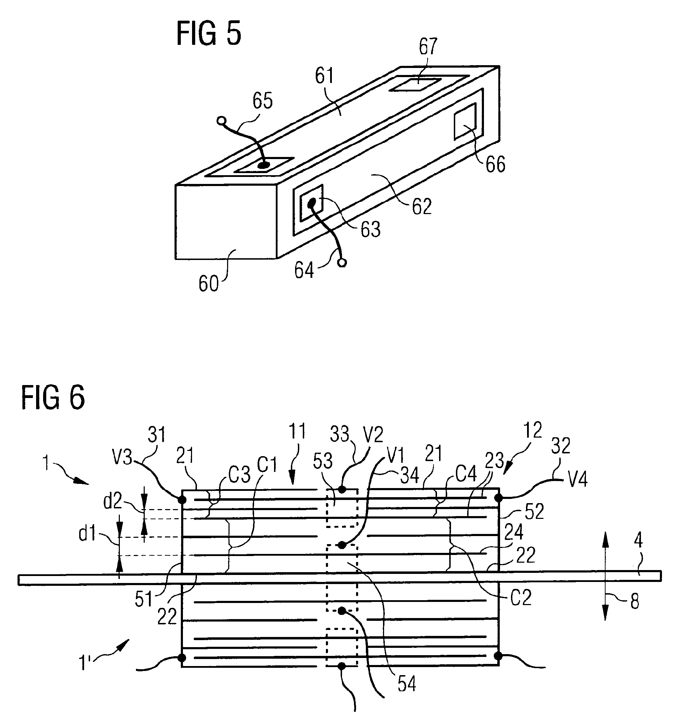

Figur 5 zeigt in grober schematischer Darstellung eine Anwendung als Aktuator. Bei diesem Ausführungsbeispiel sind zwei nicht erfindungsgemäße piezoelektrische Bauelemente 61 und 62 in einem 90°-Winkel zueinander auf dem anzuregenden Element 60 angeordnet. Die Anordnung um 90° versetzt erlaubt eine Anregung in zwei Raumrichtungen. Des Weiteren umfasst jedes Bauelement zwei Kontaktelemente 63, 66 sowie 65 und 67, an denen eine Wechsel- beziehungsweise Gleichspannung angelegt werden kann. Eine Kraftübertragung auf das Element 60 erfolgt durch eine feste mechanische Kopplung der beiden piezoelektrischen Bauelemente 61 und 62, beispielsweise durch einen Kleber. Dieser ist zweckmäßig derart ausgestaltet, das einer eine Verspannung aufgrund einer angelegten Gleichspannung kompensiert und somit vom Körper 60 entkoppelt. Biegeschwingungen verursacht durch eine angelegte Steuerspannung werden hingegen übertragen.

Die beiden piezoelektrischen Bauelemente 61 und 62 besitzen eine weitestgehend übereinstimmende Resonanzfrequenz. Aufgrund geringer Toleranzen in den geometrischen Abmessungen passen die natürlichen Resonanzfrequenzen der beiden piezoelektrischen Bauelemente jedoch nicht vollständig. Dadurch kommt es bei einer Anregung mit einer gemeinsamen Anregungsfrequenz in einem der beiden Bauelemente zu einer stärkeren Dämpfung, wodurch insgesamt der Wirkungsgrad der Anordnung reduziert wird. Zur Abstimmung der Resonanzfrequenzen der beiden piezoelektrischen Bauelemente 61 und 62 aneinander werden nun geeignete Gleichspannungen den Kontakten 63, 66 beziehungsweise 65 und 67 zugeführt. Die Gleichspannung verursacht eine konstante, aber auch reversible Verspannung in den piezoelektrischen Bauelementen und ändert so deren Resonanzfrequenz geringfügig.

Eine weitere Anwendungsvariante zeigt Figur 6, bei der eine Membran 4 zwischen zwei gleichartig ausgebildeten nicht erfindungsgemäßen piezoelektrischen Bauelementen angeordnet ist. Die Bauelemente 1 und 1' sind auf unterschiedlichen Seiten des Membrans 4 angebracht und weisen ähnliche geometrische Eigenschaften auf. Dennoch ist aufgrund von Bauteiltoleranzen eine leichte Abweichung in den geometrischen Dimensionen gegeben, wodurch die Resonanzfrequenzen der beiden piezoelektrischen Bauelemente 1, 1' beziehungsweise der Wandler gegeneinander verschoben sind.

Das piezoelektrische Bauelement 1' ist auf die gleiche Weise wie das Bauelement 1 aufgebaut. Letzteres umfasst einen ersten Teilbereich 11 mit zwei leitend übereinander angeordneten Wandlerelementen C1 und C3. Ein zweiter Teilbereich 12 enthält ebenfalls zwei leitend miteinander verbundene, übereinander angeordnete Wandlerelemente C2 und C4. Die Dicke der piezoelektrischen Schichten im Bereich der Wandlerelemente C1 und C2 der beiden Teilbereiche beträgt D1. Die Wandlerelemente C3 und C4 weisen piezoelektrische Schichten mit einer geringeren Dicke D2 als die Wandlerelemente C1 und C2 auf. In der Ausgestaltung sind die Wandlerelemente C1 und C2 der Membran 4 zugewandt.

Mit dem kleineren Abstand C2 zwischen den unterschiedlich gepolten Elektroden in dem von der Membran 4 abgewandten Bereich des Körpers 1 gelingt es, eine größere Auslenkungsamplitude des piezoelektrischen Materials in den Teilbereichen 11 und 12 zu erzielen. Durch die Änderung des Abstands zwischen den Elektroden der Wandlerelemente C3 und C4 der beiden Teilbereiche 11 und 12 relativ zu den Wandlerelementen C1 beziehungsweise C2 gelingt eine besonders effiziente elektromechanische Wandlung. Die beiden äußeren Flächen 51 und 52 sind wiederum über entsprechende Kontaktleitungen 31 und 32 nach außen geführt. Weiterhin sind die gemeinsamen Elektroden 23 der beiden Wandlerelemente C3 beziehungsweise C4 an die hier angedeutete gestrichelte Fläche 53 geführt und mit dem Kontakt 33 elektrisch leitend verbunden. Eine vierte gemeinsame Elektrode 24 in den Elementen C1 und C2 der beiden Teilbereiche 11 und 12 des Wandlers ist an die Fläche 54 angeschlossen.

In einem Betrieb wird beispielsweise ein erstes Steuersignal $V_1$ mit einer Anregungsfrequenz an die gemeinsame Elektrode 24 über die Kontaktfläche 54 an die Wandlerelemente C1 und C2 angelegt. Ein zweites Steuersignal $V_2$ mit der gleichen oder einer anderen Anregungsfrequenz zur Superposition wird an die gemeinsamen Elektroden 23 der Wandlerelemente C3 und C4 über die Kontaktierung 33 angelegt. Weitere Steuersignale mit einem Gleichspannungsanteil können vorzugsweise den gemeinsamen Elektroden der übereinander angeordneten Wandlerelemente zugeführt werden. Im Einzelnen wird ein Steuersignal $V_3$ an die ersten Elektroden 21 der Wandlerelemente C1 und C3 und ein Steuersignal $V_4$ an die zweiten Elektroden 22 der beiden Wandlerelemente C2 und C4 angelegt. Während in dieser Ausgestaltung die Steuersignale $V_3$ und $V_4$ Gleichspannungssignale darstellen und die Steuersignale $V_1$ und $V_2$ Steuerspannungen mit der Anregungsfrequenz beinhalten, können in alternativen Ausführungsformen die jeweiligen Steuersignale je nach Variante Bezugspotentiale, Gleichspannungen, Steuerspannungen oder überlagerte Signale beziehungsweise Kombination derer sein.

Zur Abstimmung der beiden piezoelektrischen Bauelemente 1 und 1' werden die entsprechend zugeführten Gleichspannungen $V_3$, $V_4$ so gewählt, dass die durch die angelegten Gleichspannungen induzierten geometrischen Veränderungen die Resonanzfrequenz der beiden Bauelemente aneinander angleichen. Auf diese Weise werden die natürlichen Resonanzfrequenzen der beiden piezoelektrischen Bauelemente aufeinander abgestimmt. Eine Anregung durch die zugeführte Steuerspannung erfolgt vorzugsweise mit einer Anregungsfrequenz, die der abgestimmten Resonanzfrequenz entspricht, um Dämpfungen und Verluste möglichst zu reduzieren.

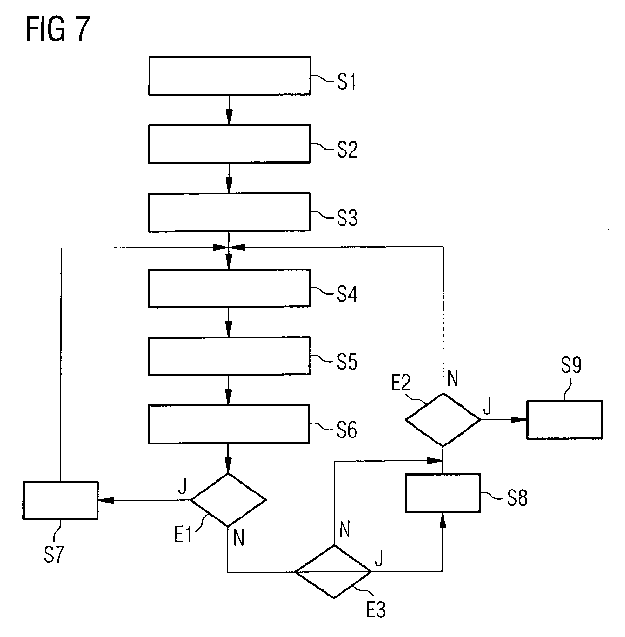

Figur 7 zeigt eine schematische Darstellung eines einfachen Verfahrens zur Abstimmung einer Resonanzfrequenz eines piezoelektrischen Bauelementes. Dabei schwingt das piezoelektrische Bauelement, welches einen Wandler in einer Mehrschichtstruktur aufweist, in einem Biegemodus mit einer natürlichen durch die geometrischen Parameter und das Elastizitätsmodul abhängigen Resonanzfrequenz. Hierbei ist jedoch aufgrund von bauteilbedingten Toleranzen die natürliche Resonanzfrequenz von der gewünschten Anregungsfrequenz leicht unterschiedlich, sodass zur Verbesserung der Anregung und Reduzierung der Dämpfung eine Abstimmung der Resonanzfrequenz zweckmäßig erscheint.

In Schritt S1 wird das piezoelektrische Bauelement bereitgestellt und anschließend in Schritt S2 eine Steuerspannung mit der Anregungsfrequenz an das Bauelement angelegt, auf die das Bauelement abgestimmt werden soll. Die Steuerspannung bildet ein sich zeitlich änderndes elektrisches Feld aus. Dadurch beginnt das Bauelement mechanisch zu schwingen. Die Schwingung selbst ist von der Richtung des Feldes, der Geometrie und des Elastizitätsmoduls abhängig und ist bevorzugt eine Biegeschwingung verursacht durch eine senkrecht zum elektrischen Feld erzeugte Längenänderung. Dies wird ach als transversaler piezoelektrischer Effekt bezeichnet. Aufgrund der Abweichung der Anregungsfrequenz f von der natürlichen Resonanzfrequenz tritt eine mehr oder weniger starke Dämpfung auf. Diese äußert sich beispielsweise in einer geringeren Amplitude, größeren Dämpfung, aber auch größere Verlustleistung der zugeführten Energie.

Sodann wird in Schritt S3 ein Parameter erfasst, aus dem sich ein Maß für die Abweichung ermitteln lässt. Dieser kann beispielsweise die Dämpfung, die Amplitude der Schwingung, der zeitliche Verlauf, oder auch die zugeführte Energie sein, um eine bestimmte Schwingungsamplitude zu erreichen.

Anschließend wird in Schritt S4 eine Gleichspannung angelegt, die zu einer geometrischen Änderung beziehungsweise einer Änderung des Elastizitätsmoduls führt. Dadurch ändert sich auch das innere mechanische Kapazitätsäquivalent des Bauelementes, welches wiederum zu einer Änderung der Resonanzfrequenz führt.

In Schritt S5 wird die angelegte Gleichspannung nun mit der bereits in Schritt S2 angelegten Steuerspannung überlagert. Das Bauteil fängt nun erneut mit der Anregungsfrequenz zum Schwingen an. Je nach Verschiebung der Resonanzfrequenz aufgrund der angelegten Gleichspannung verändert sich auch die Abweichung der nunmehr geänderten natürlichen Resonanzfrequenz von der Anregungsfrequenz. Wird diese geringer, so verringert sich in einem entsprechenden Maße auch die Dämpfung beziehungsweise die Amplitude der Auslenkung des piezoelektrischen Bauelementes steigt entsprechend. Der für die Abweichung charakterisierende Parameter wird in Schritt S6 erneut erfasst und mit dem bereits erfassten Wert aus Schritt S3 verglichen.

Ergibt sich im Verlaufe des Vergleichs in Schritt E1, dass die Änderung der Gleichspannung zu einer Verbesserung führte, das heißt zu einer geringeren Abweichung der geänderten Resonanzfrequenz von der Anregungsfrequenz, so wird der in Schritt S4 angelegte Gleichspannungswert in Schritt S7 zwischengespeichert. Anschließend wird erneut die angelegte Gleichspannung verändert. Diese Veränderung erfolgt in die gleiche Richtung ohne Änderung der Polarität der angelegten Gleichspannung, um eine eventuell weitere Verbesserung zu erreichen. Das Verfahren wird nun mit den Schritten S4, S5 und S6 sooft wiederholt, bis der Vergleich in Schritt E1 keine Verbesserung ergibt.

In diesem Fall muss überprüft werden, ob die Schleife der Schritte S4 bis S6 bereits mehrmals durchlaufen wurden oder nicht. Dies wird in Schritt E3 überprüft.

Wenn die Schleife bereits mehrmals durchlaufen ist in Schritt S8 der Wert für die angelegte Gleichspannung ermittelt, der die bislang beste Abstimmung erzielt hat, das heißt die geringste Abweichung der geänderten natürlichen Resonanzfrequenz von der Anregungsfrequenz ergibt. Das Verfahren kann hier beendet werden.

Ergibt hingegen der Vergleich in Schritt E1 bereits bei einem erstmaligen Anlegen der Gleichspannung in Schritt S4 bereits, dass sich die Abweichung der geänderten Resonanzfrequenz von der Anregungsfrequenz vergrößert, so wird gemäß dem Vergleichsschritt E3 der Schritt S8 ausgelassen und mit dem Vergleichsschritt E2 das Verfahren fortgesetzt. In diesem wird überprüft, ob bereits ein Polarisationswechsel beim Anlegen der Gleichspannung erfolgt ist. Ist dies der Fall, so wird vorliegend davon ausgegangen, dass bereits die beste Übereinstimmung zwischen der Anregungsfrequenz und der natürlichen Resonanzfrequenz erreicht ist. Das Verfahren wird dann in Schritt S9 beendet. Wenn hingegen der Vergleichsschritt E2 ergibt, dass bislang noch kein Polarisationswechsel stattgefunden hat, wird die Polarisation der angelegten Gleichspannung verändert und das Verfahren erneut mit Schritt S4 fortgesetzt.

Das in Figur 7 vorgestellte Verfahren zeigt eine einfache Ausführung zur Abstimmung einer natürlichen Resonanzfrequenz eines piezoelektrischen Bauelementes an eine gewünschte Anregungsfrequenz. Bei dem Verfahren wird durch die angelegte Gleichspannung das mechanische Kapazitätsäquivalent $C_M$ verändert, wodurch sich ebenso eine Änderung in der natürlichen Resonanzfrequenz des piezoelektrischen Bauelementes ergibt. Auf diese Weise lassen sich durch eine mechanische Bearbeitung eines piezoelektrischen Bauelementes in einer Vielschichtanordnung die Resonanzfrequenz grob einstellen, ohne dass aufwändige mechanische Nachbearbeitungen notwendig sind. Eine Feineinstellung der natürlichen Resonanzfrequenz am individuellen Bauteil erfolgt über das Anlegen einer Gleichspannung. Dadurch können beliebige Anordnungen piezoelektrischer Bauelemente mit leicht unterschiedlichen Resonanzfrequenzen aufeinander abgestimmt werden. Zudem lassen sich Einflüsse äußerer Parameter auf piezoelektrische Bauelemente, beispielsweise dem Einfluss der Temperatur, kompensieren. Das vorgeschlagene Verfahren ist besonders wirksam in piezoelektrischen Bauelementen in einer Vielschichtanordnung, bei der eine Vielzahl Elektroden übereinander durch dünne piezoelektrische Schichten angeordnet sind. Diese können im Bereich weniger $\mu$m liegen, wodurch auch bei geringen Gleich- beziehungsweise Steuerspannungen eine große Auslenkung erzeugt wird. Dies erlaubt die Herstellung von kleinsten Motoren, Trafos, Lautsprechern in einer Mehrfachanordnung mit geringen Betriebsspannungen und gleichzeitig hohem gemeinsamen Wirkungsgrad.

Bezugszeichenliste

| 1 | piezoelektrisches Bauelement |
| 10 | piezoelektrische Schicht |
| 11, 12 | Teilbereiche |
| 21, 22, 21', 22' | Elektroden |
| 23, 23', 24, 24' | Elektroden |
| 51, 52 | metallische Flächen |
| 53, 54 | metallische Flächen |
| 31, 32, 33, 34 | Kontaktierungen |
| 51, 51', 52, 52' | metallische Flächen |
| 53, 54, 53', 54' | metallische Flächen |
| C1, C2, C3, C4 | Wandlerelemente |
| l | Länge |

**Patentansprüche**

1. Verfahren zur Abstimmung einer Resonanzfrequenz eines piezoelektrischen Bauelements (1) aufweisend einen in drei Raumrichtungen ausgedehnten Wandler, wobei die Resonanzfrequenz abhängig von einer Ausdehnung in mindestens eine der Raumrichtungen und/oder einem materialabhängigen Elastizitätsmodul ist, der Wandler aufweisend eine Schichtstruktur mit wenigstens vier alternierend übereinander angeordneten Elektroden (21' bis 24'), wobei erste Elektroden (21') und zweite Elektroden mit den an beiden Enden angebrachte Flächen (51', 52') des Bauelementes verbunden sind, dritte Elektroden (23') an eine dritte Fläche (53') und vierte Elektroden an eine vierte Fläche (54') angeschlossen sind, wobei dritte und vierte Flächen (53', 54') entlang der Längsrichtung des Bauelementes angeordnet sind, umfassend:

   - Anlegen einer Gleichspannung ($V_3$, $V_4$) an zwei der vier Flächen, sodass eine Änderung in der Resonanzfrequenz aufgrund einer aus einer Änderung der Ausdehnung in die mindestens eine der Raumrichtungen und dem Elastizitätsmodul erzeugt wird;
   - Anlegen einer Steuerspannung ($V_1$, $V_2$) zur Erzeugung der Schwingung an die anderen zwei der vier Flächen (51' bis 54') mit einer Anregungsfrequenz, die im Wesentlichen der geänderten Resonanzfrequenz entspricht.

2. Verfahren nach Patentanspruch 1,
   bei dem die angelegte Gleichspannung ein elektrisches Feld erzeugt, welches im Wesentlichen senkrecht zu der durch das elektrische Feld hervorgerufenen Änderung der Ausdehnung in die mindestens eine der Raumrichtungen ist.

3. Verfahren nach einem der Patentansprüche 1 bis 2, bei dem die Dicken der verschiedenen piezoelektrischen Schichten zwischen den einzelnen Elektroden (21' bis 24') unterschiedlich gewählt sind.

4. Verfahren nach einem der Patentansprüche 1 bis 3, bei dem zwei benachbarte Elektroden der Schichtstruktur den gleichen Abstand voneinander aufweisen.

5. Verfahren nach einem der Patentansprüche 1 bis 4, bei dem die Schichtstruktur des Wandlers eine erste Teilschichtstruktur (11) und eine hiervon durch einen im Wesentlichen feldfreien Raum (13) beabstandete zweite Teilschichtstruktur (12) umfasst.

6. Verfahren nach Patentanspruch 5,
bei dem Elektroden der ersten und zweiten Teilschichtstruktur (11, 12) in einer Ebene angeordnet sind.

7. Verfahren nach einem der Patentansprüche 1 bis 6, bei dem der Wandler eine piezoelektrische Schicht (10) umfasst, die zwischen den Elektroden (21, 22, 22') angeordnet sind und eine Keramik mit piezoelektrischen Eigenschaften aufweist.

8. Verfahren nach einem der Patentansprüche 1 bis 7, bei dem das Anlegen eine Gleichspannung umfasst:

 - Anlegen einer Steuerspannung mit einer Anregungsfrequenz zur Erzeugung der Schwingung;
 - Erfassen eines von der erzeugten Schwingung abhängigen Parameters;
 - Anlegen der Gleichspannung zur Änderung der Resonanzfrequenz;
 - Anlegen der Steuerspannung mit der Anregungsfrequenz;
 - erneutes Erfassen des von der Schwingung abhängigen Parameters;
 - Ändern der angelegten Gleichspannung in Antwort auf einen Vergleich der erfassten Parameter.

9. Verfahren nach Patentanspruch 8,
bei dem der Parameter wenigstens eines der folgenden umfasst:

 - eine Amplitude der erzeugten Schwingung,
 - eine Auslenkung des Wandlers,
 - eine Dämpfung der erzeugten Schwingung,
 - einen zeitlichen Verlauf der erzeugten Schwingung,
 - eine zeitliche Amplitudenänderung,
 - eine Verlustleistung abgeleitet aus der zugeführten Steuerspannung.

10. Verfahren nach einem der Patentansprüche 1 bis 8, bei dem nach dem Anlegen einer Gleichspannung die geänderte Resonanzfrequenz erfasst wird, die als Anregungsfrequenz der angelegten Steuerspannung verwendet wird.

11. Verfahren nach einem der Patentansprüche 1 bis 10, bei dem die erzeugte Schwingung ein Biegemodus mit einer Auslenkung des Wandlers senkrecht zur Längsrichtung des Wandlers ist.

**Claims**

1. Method for tuning a resonant frequency of a piezoelectric component (1) comprising a transducer extended in three spatial directions wherein the resonant frequency is dependent on an extent in at least one of the spatial directions and/or a material-dependent modulus of elasticity, the transducer comprising a layer structure with at least four electrodes (21' to 24') arranged alternately one above another, wherein first electrodes (21') and second electrodes are connected to the surfaces (51', 52') of the component that are provided at both ends, third electrodes (23') are connected to a third surface (53') and fourth electrodes are connected to a fourth surface (54'), wherein third and fourth surfaces (53', 54') are arranged along the longitudinal direction of the component, comprising:

 - applying a DC voltage ($V_3$, $V_4$) to two of the four surfaces, such that a change in the resonant frequency is generated on account of one from a change in the extent in the at least one of the spatial directions and the modulus of elasticity;
 - applying a control voltage ($V_1$, $V_2$) for generating the oscillation to the other two of the four surfaces (51' to 54') with an excitation frequency that substantially corresponds to the changed resonant frequency.

**2.** Method according to Patent Claim 1,
wherein the applied DC voltage generates an electric field that is substantially perpendicular to the change in the extent in the at least one of the spatial directions that is brought about by the electric field.

**3.** Method according to either of Patent Claims 1 and 2,
wherein the thicknesses of the different piezoelectric layers between the individual electrodes (21' to 24') are chosen differently.

**4.** Method according to any of Patent Claims 1 to 3, wherein two adjacent electrodes of the layer structure are at the same distance from one another.

**5.** Method according to any of Patent Claims 1 to 4, wherein the layer structure of the transducer comprises a first partial layer structure (11) and a second partial layer structure (12) spaced apart therefrom by a substantially field-free space (13).

**6.** Method according to Patent Claim 5, wherein electrodes of the first and second partial layer structures (11, 12) are arranged in one plane.

**7.** Method according to any of Patent Claims 1 to 6, wherein the transducer comprises a piezoelectric layer (10) arranged between the electrodes (21, 22, 22') and comprising a ceramic having piezoelectric properties.

**8.** Method according to any of Patent Claims 1 to 7, wherein applying a DC voltage comprises:

- applying a control voltage having an excitation frequency for generating the oscillation;
- detecting a parameter dependent on the generated oscillation;
- applying the DC voltage for changing the resonant frequency;
- applying the control voltage having the excitation frequency;
- detecting anew the parameter dependent on the oscillation;
- changing the applied DC voltage in response to a comparison of the detected parameters.

**9.** Method according to Patent Claim 8,
wherein the parameter comprises at least one of the following:

- an amplitude of the generated oscillation,
- a deflection of the transducer,
- a damping of the generated oscillation,
- a temporal profile of the generated oscillation,
- a change in amplitude over time,
- a power loss derived from the control voltage fed.

**10.** Method according to any of Patent Claims 1 to 8, wherein, after applying a DC voltage, the changed resonant frequency, which is used as excitation frequency of the applied control voltage, is detected.

**11.** Method according to any of Patent Claims 1 to 10, wherein the generated oscillation is a bending mode with a deflection of the transducer perpendicular to the longitudinal direction of the transducer.

**Revendications**

**1.** Procédé de détermination de la fréquence de résonance d'un composant piézoélectrique (1) qui présente un convertisseur s'étendant dans trois directions de l'espace,
la fréquence de résonance dépendant d'une dilatation dans au moins l'une des directions de l'espace et/ou un module d'élasticité dépendant du matériau,
le convertisseur présentant une structure stratifiée qui compte au moins quatre électrodes (21' à 24') disposées en alternance les unes au-dessus des autres,
des premières électrodes (21') et des deuxièmes électrodes étant reliées aux surfaces (51', 52') du composant disposées sur les deux extrémités, des troisièmes électrodes (23') étant raccordées à une troisième surface (53') et des quatrièmes électrodes à une quatrième surface (54'), les troisièmes et quatrièmes surfaces (53', 54') étant disposées dans le sens de la longueur du composant,
le procédé comportant les étapes qui consistent à :

appliquer une tension continue ($V_3$, $V_4$) sur deux des quatre surfaces de manière à former une modification de la fréquence de résonance suite à une modification de l'extension dans la ou les directions de l'espace et du module d'élasticité,

appliquer une tension de commande ($V_1$, $V_2$) en vue de former l'oscillation sur les deux autres des quatre surfaces (51' à 54'), à une fréquence d'excitation qui correspond essentiellement à la fréquence de résonance modifiée.

2. Procédé selon la revendication 1, dans lequel la tension continue appliquée forme un champ électrique qui est essentiellement perpendiculaire à la modification de l'extension dans la ou les directions de l'espace provoquée par le champ électrique.

3. Procédé selon l'une des revendications 1 et 2, dans lequel les différentes couches piézoélectriques entre les différentes électrodes (21' à 24') ont des épaisseurs différentes.

4. Procédé selon l'une des revendications 1 à 3, dans lequel deux électrodes voisines de la structure stratifiée présentent la même distance mutuelle.

5. Procédé selon l'une des revendications 1 à 4, dans lequel la structure stratifiée du convertisseur comporte une première structure stratifiée partielle (11) et une deuxième structure stratifiée partielle (12) maintenue à distance de la première par un espace (13) essentiellement exempt de champ.

6. Procédé selon la revendication 5, dans lequel les électrodes de la première et de la deuxième structure stratifiée partielle (11, 12) sont disposées dans un plan.

7. Procédé selon l'une des revendications 1 à 6, dans lequel le convertisseur comporte une couche piézoélectrique (10) disposée entre les électrodes (21, 22, 22') et une céramique à propriétés piézoélectriques.

8. Procédé selon l'une des revendications 1 à 7, dans lequel l'application d'une tension continue comporte :

l'application d'une tension de commande à une fréquence d'excitation pour former l'oscillation,
la saisie d'un paramètre qui dépend de l'oscillation ainsi formée,
l'application de la tension continue en vue de modifier la fréquence de résonance,
l'application de la tension de commande à la fréquence d'excitation,
la saisie une nouvelle fois du paramètre dépendant de l'oscillation et
la modification de la tension continue appliquée en réponse à une comparaison des paramètres qui ont été saisis.

9. Procédé selon la revendication 8, dans lequel le paramètre comporte au moins l'un des paramètres suivants :

l'amplitude de l'oscillation formée,
la déformation du convertisseur,
l'amortissement de l'oscillation formée,
l'évolution dans le temps de l'oscillation qui a été formée,
une modification de l'amplitude en fonction du temps et
une puissance de perte découlant de la tension de commande qui a été apportée.

10. Procédé selon l'une des revendications 1 à 8, dans lequel la fréquence de résonance modifiée, utilisée comme fréquence d'excitation de la tension de commande appliquée, est saisie après l'application d'une tension continue.

11. Procédé selon l'une des revendications 1 à 10, dans lequel l'oscillation formée est un mode de flexion qui déforme le convertisseur perpendiculairement au sens de la longueur du convertisseur.

**FIG 1**

**FIG 2A**

**FIG 2B**

**FIG 2C**

FIG 3A

FIG 3B

FIG 4A

FIG 4B

## FIG 5

## FIG 6

## FIG 7

# FIG 8

f = 308.0 + 0.1754 DC BIAS

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6346764 B1
- EP 1126602 A
- US 5446306 A